# EUROPEAN PATENT SPECIFICATION

(11) **EP 0 375 226 B1**
(45) Date of publication and mention of the grant of the patent: **06.03.1996**
(21) Application number: 89312867.8
(22) Date of filing: 11.12.1989
(51) Int. Cl.: G11C 5/00, G11C 11/412, H01L 27/11

(54) **An seu hardened memory cell**
Gegen weiche Fehler widerstandsfähige Speicherzelle
Cellule de mémoire résistant aux erreurs molles

(30) Priority: 21.12.1988 US 288541
(43) Date of publication of application: 27.06.1990
(73) Proprietor: TEXAS INSTRUMENTS INCORPORATED, Dallas Texas 75265 (US)
(72) Inventor: Houston, Theodore W., Richardson Texas 75080 (US); Blake, Terence G. W., Dallas Texas 75243 (US)
(74) Representative: Abbott, David John

(56) References cited:
- EP-A- 0 217 307
- US-A- 4 760 557
- US-A- 4 805 148
- IBM TECHNICAL DISCLOSURE BULLETIN vol. 29, no. 7, December 1986, NEW YORK US pages 2826 - 2827; 'SRAM cell stability enhancement via DRAM technology'
- PATENT ABSTRACTS OF JAPAN vol. 6, no. 258 (P-163) 17 December 1982 & JP-A-57 152 591
- PATENT ABSTRACTS OF JAPAN vol. 5, no. 141 (E-073) 5 September 1981 & JP-A-56 074 960
- PATENT ABSTRACTS OF JAPAN vol. 11, no. 113 (E-497) 9 April 1987 & JP-A- 61 260 668
- PATENT ABSTRACTS OF JAPAN vol. 3, no. 74 (E-119) 26 June 1979 & JP-A-54 052 477

## Description

### BACKGROUND OF THE INVENTION

The invention concerns radiation hardened memory cells as indicated in the preamble of claim 1 and eg. known from US-A- 4 760 557.

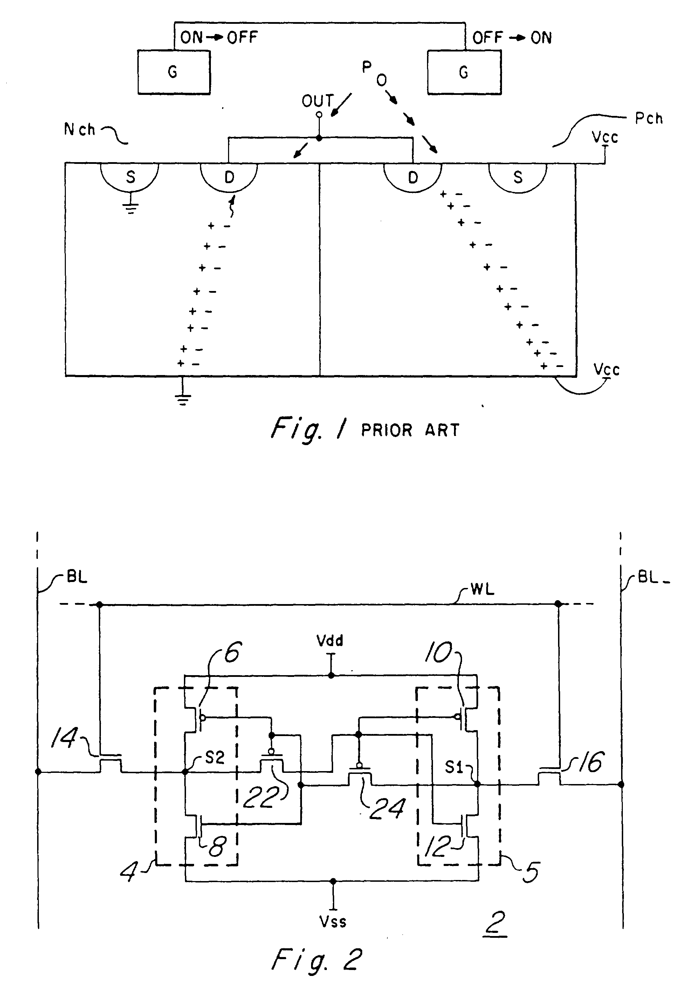

Static memory cells in certain environments such as communication satellite orbital space are, or will likely be particularly susceptible to soft errors or single event upsets (SEUs). See E.G. Gussehower, K. A. Lynch and D. H. Brenteger, "DMPS Dosimetry Data: A Space Measurement and Mapping of Upset Causing Phenomena," IEEE Trans. Nuclear Science NS-34, pp. 1251-1255 (1987) and H. T. Weaver, et al., "An SEU Tolerant Memory Cell Derived from Fundamental Studies of SEU Mechanisms in SRAM," IEEE Trans. Nuclear Science, NS-34, pp. 1281-1286 (1987). A soft error or single event upset (SEU) typically is caused by electron-hole pairs created by, and along the path of a single energetic particle as it passes through an integrated circuit, such as a memory. Should the energetic particle generate the critical charge in the critical volume of a memory cell, then the logic state of the memory is upset. This critical charge, by definition, is the minimum amount of electrical charge required to change the logic state of the memory cell. The critical charge may also enter the memory through direct ionization from cosmic rays. See T. C. May and M. H. Woods, "Alpha Particle Induce Soft Errors in Dynamic Memories," IEEE Trans. Electronic Devices, ED-26, p. 2 (1979) and J.C. Pickel, J. T. Blaudfood, Jr., "CMOS RAM Cosmic Ray-Induce Error Rate Analysis," IEEE Trans. on Nuclear Science, Vol. NS-28, pp. 3962-3967 (1981). Alternatively, the critical charge may result from alpha particles (helium nuclei). One example of SEU can be seen in figure 1 which illustrates a cross-sectional view of a CMOS inverter. When alpha particle p strikes bulk semiconductor material in p-channel MOS transistor Pch, it generates electron-hole pairs as shown by the respective minus and plus marks. Assuming that the n-channel transistor Nch is on and that p-channel transistor P-ch is off, the holes (indicated by plus signs) which collect (see arrows toward drain D) at drain D can change the voltage at output OUT from a logic low to a logic high. The electrons as indicated by the minus signs will diffuse toward circuit supply voltage Vcc. A charge generating particle hit on transistor Nch has the opposite effect with positive charge drifting towards ground and negative charges collecting at output OUT, thus possibly changing the logic state of the inverter.

A memory cell which provides hardening against SEU was described in US- application serial number 241,681, filed September 7, 1988 (EP-A-0 357 982, cited under Art. 54(3)). A schematic drawing of this cell is illustrated in figure 2. Memory cell 2 is constructed according to well known methods of cross-coupled inverter realization and thus CMOS inventor are used in memory cell 2. A first CMOS inverter 4 in memory cell 2 is made up of p-channel transistor 6 and n-channel transistor 8 having their source-to-drain paths connected in series between Vdd and ground, and having their gates tied together. The second CMOS inverter 5 in memory cell 2 is similarly constructed, with p-channel transistor 10 and n-channel transistor 12 having their source-to-drain paths connected in series between Vcc and ground and their gates also common. The cross-coupling is accomplished by the gates of transistors 6 and 8 being connected to the drains of transistors 10 and 12 being connected to the drains of transistors 10 and 12 (node S1 of figure 2), and by the gates of transistors 10 and 12 being connected to the drains of transistors 6 and 8 (node S2 of figure 2). The above described arrangement and structure of inverter 4 coupled to inverter 5 are commonly referred to as cross-coupled inverters, while the lines connecting gates and drains are each referred to as a cross-coupling line. N-channel transistor 14 has its source-to-drain path connected between node S2 and a first bit line BL, and has its gate connected to word line WL. N-channel pass transistor 16 similarly has its source-to-drain path connected between node S1 and a second bit line BL_, and has its gate also connected to word line WL. Pass transistors 14, 16 when enabled, allow data to pass into and out of memory cell 2 from bit lines BL and BL respectively. Bit lines BL and BL_ carry data into and out of memory cell 2. Pass transistors 14, 16 are enabled by word line WL which is a function of the row address in an SRAM. The row address is decoded by a row decoder in the SRAM such that one out of n word lines is enabled, where n is the number of rows of memory cells in the memory which is a function of memory density and architecture. P-channel transistors 22 and 24 are connected across an associated cross-coupling line joining the input of one inverter to the output of another inverter.

Additionally, the gate of transistor 22 is common with that of transistor 6 and the gate of transistor 24 is common with that of transistor 10. This circuit can be built on a thin film which lies on an insulator such as is done in silicon on insulator technology (SOI).

In operation, the voltages of nodes S1 and S2 will necessarily be logical complements of one another, due to the cross-coupled nature of CMOS inverters 4,5 within memory cell 2. When word line WL is energized by the row decoder (not shown), according to the row address received at address inputs to an address buffer (not shown) connected to the row decoder, pass transistors 14, 16 will be turned on, coupling nodes S1 and S2 to bit lines BL_ and BL respectively. Accordingly, when word line WL is high, the state of memory cell 2 can establish a differential voltage on BL and BL_. Alternatively, peripheral circuitry forcing a voltage on BL and BL_ can alter the state of memory cell 2. The sizes of the transistors shown in figure 1 are generally chosen such that when pass transistors 14, 16 are turned on by word line WL; a differentially low voltage at bit line BL with respect to bit line BL_ can force node S2 to a logic low level; and a differentially low voltage at bit line BL_ with respect to bit line BL can force node S1 to a logic low level. However, the sizes of the transistors shown in figure 2 are also chosen such that when transistors 14 and 16 are on; a differentially high voltage at bit line BL with respect to bit line BL_ will not force node S2 high; nor will a differentially high voltage at bit line BL_ with respect to bit line BL force node S1 high. Therefore writing into memory cell 2 is accomplished by pulling the desired bit line and thus the desired side of cell 2 at either node S1 or node S2 low, which in turn due to feedback paths in cell 2, causes the opposite side of cell 2 to have a logic high state.

SEU protection is provided by the circuit shown in Figure 2 in that transistors 22 and 24 provide additional delay in the feedback paths so as to allow recovery of the memory cell from an energetic particle hit. The gate capacitances of transistors 22 and 24 provide SEU protection both by increasing the feedback delay and by decreasing the voltage change incurred by collection of a given amount of charge. However, the layout for the cell shown in Figure 2 does not necessarily optimize the amount of capacitance achieved which is capable of being produced within the given cell size. For instance, in certain situations even more SEU hardening may be required than possible within the memory cell of Figure 2 within a given cell size.

### OBJECTS OF THE INVENTION

It is an object of the invention to provide a new and improved memory cell.

It is another object of the invention to provide a new and improved memory cell with SEU protection.

It is still another object of the invention to provide for a memory, optimal SEU protection within a given SRAM cell size.

### SUMMARY OF THE INVENTION

According to one aspect of the invention there is provided a memory cell comprising:
two cross-coupled inverters each including a p-channel transistor and an n-channel transistor, said p and n channel transistors in each inverter sharing a common gate, each inverter further including a first diode connected to and between the n-channel transistor and the p-channel transistor; characterized by
second diodes connected between and to the gate of a selected transistor of one inverter and a drain of a selected transistor of the other inverter.

### BRIEF DESCRIPTION OF THE DRAWINGS

Figure 1 is a cross-sectional view of a CMOS inverter.

Figure 2 is a schematic drawing of a prior art memory cell.

Figure 3 illustrates a schematic drawing of a first preferred embodiment of the invention.

Figure 4 is a preferred embodiment of the layout of the circuit of Figure 3 and it is a drawing of a portion of superimposed fabrication masks.

Figure 5 is an alternative embodiment of the layout for the memory cell.

Figure 6 is a schematic drawing of the circuit achieved from the layout shown in Figure 5.

Figure 7a is a schematic drawing of another alternative embodiment of the invention.

Figure 7b is a layout of the circuit of Figure 7a which illustrates superimposed mask portions.

Figure 8a is an alternative embodiment of the schematic drawing illustrated in Figure 7a.

Figure 8b illustrates a layout for the circuit shown in Figure 8a.

Figures 9a, 10a, 11a, 12a, and 13a illustrate schematic drawings of one half of a memory cell including symmetrical halves.

Figures 9b, 10b, 11b, 12b, and 13b illustrate cell layouts of the schematic drawings shown in 9a, 10a, 11a, 12a, and 13a respectively.

### DETAILED DESCRIPTION OF THE INVENTION

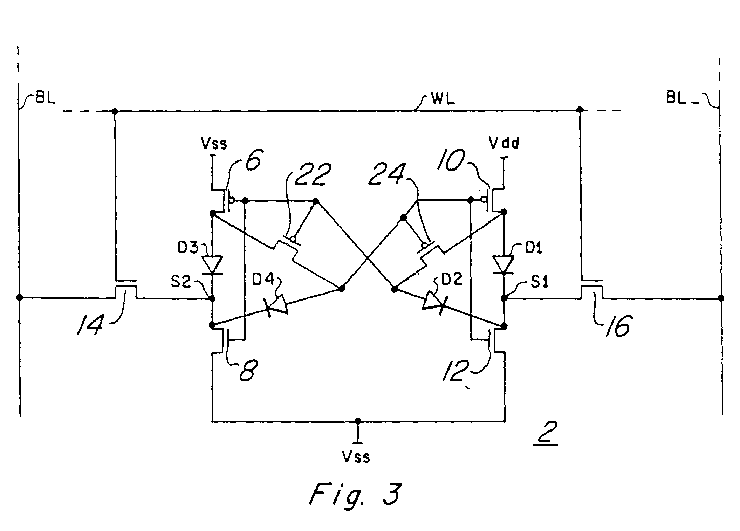

Figure 3 illustrates a schematic drawing of a first preferred embodiment of the invention. This circuit is like that shown in figure 2 except that diode D1 is connected to and between the drain of transistor 10 and node S1, and diode D2 is connected to a source/drain of transistor 24 and node S1. Other differences are that diode D3 is connected to and between the drain of transistor 6 and node S2, and diode D4 is connected to a source/drain of transistor 22 and node S2.

A description of the operation of the circuit shown in figure 3 follows. Should node S2 be low in voltage relative to node S1, an energetic particle hit on the body of transistor 12 may lower the voltage at node S1, but the delay introduced by the combination of diodes D1, D2 and transistor 24 allows recovery of the cell from the hit such that the voltage on node S1 returns to its voltage state just before the hit. Should node S2 be high in voltage relative to node S1, an energetic particle hit on the body of transistor 10 will not propagate a resulting voltage change through the cell since paths to the other side of the cell are blocked by transistor 24 and diode D2. A similar analysis is applicable to energetic particle hits on transistors 6 and 8 since symmetrical circuit structures in the cell are involved. Thus, with node S2 low with respect to node S1, an energetic particle hit on the body of transistor 6 will not propagate a resulting voltage change through the cell since paths to the other side of the cell are blocked by transistor 22 and diode D4. If node S2 were high with respect to node S1, delay introduced by the combination of diodes D3, D4, and transistor 22 will allow recovery from an energetic particle hit on the body of transistor 8. Note that the above discussed additions to figure 2 shown in figure 3 do not substantially increase READ or WRITE cycle times of the cell.

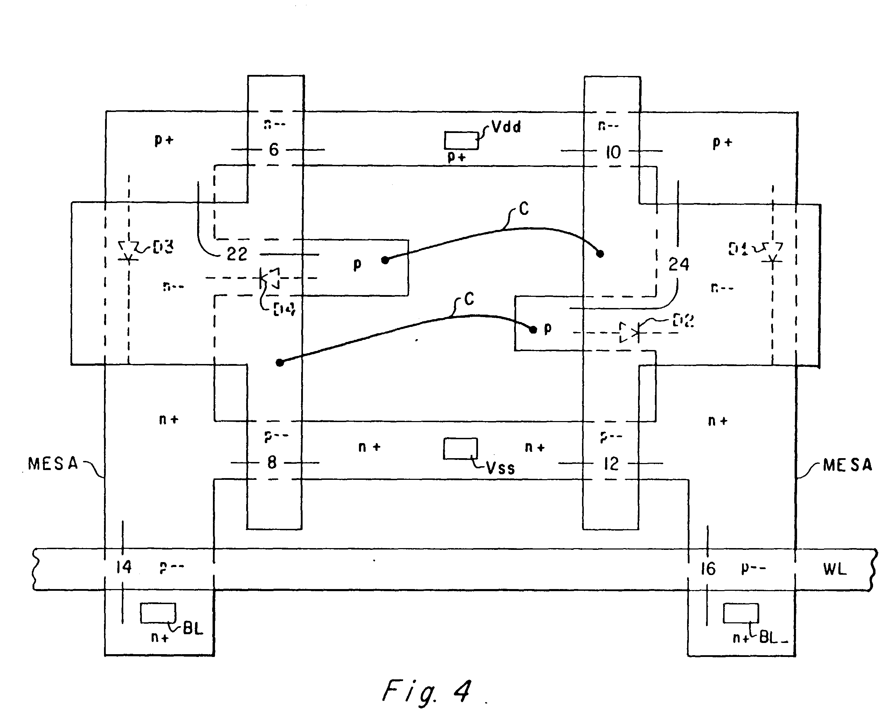

A preferred embodiment of the layout of the circuit shown in figure 3 is illustrated in figure 4 which is a drawing of a portion of superimposed fabrication masks. An advantage of this layout over the prior art includes the fact that it allows a larger amount of capacitance to be obtained in the same cell area. The positions of the labeled elements in figure 3 are indicated in figure 4. Lines on either side of label numbers indicate extention of an element over the length of the line. For optimal SEU protection, the circuit of figure 3 is built on a thin film of semiconductor material which lies on an insulator. Thus, as shown in figure 4 the circuit is built on a mesa. Doping impurity types in regions of the mesa are labeled p and n with plus or minus signs indicating a higher and lower dopant concentration respectively. Gates for transistors overlie the mesa. Mesa areas under the gate are shown by dashed lines. Diode positions are shown by diode symbols. Extension of the gate of transistor 24 across the MESA between transistors 10 and 12 results in the separation of transistors 10 and 12 by diode D1. Extra capacitance is also achieved by this extension. Additionally, diode D2 is formed from a source/drain to body of transistor 24 as shown. Likewise, the gate of transistor 22 is extended across the MESA between transistors 6 and 8. Diodes D3 and D4 are formed from a source/drain to body of transistor 22 as shown. Transistors 22 and 24 may have n-type and p-type connections to either or both their sources and drains so as to maintain a high amount of capacitance during times when both high or low voltages are on their sources and drains. Contact positions for connection to bit lines BL and BL_ are also indicated along with contact positions for voltage connections to Vdd and Vss. Lines labeled C represent cross coupling connections between opposite sides of the memory cell.

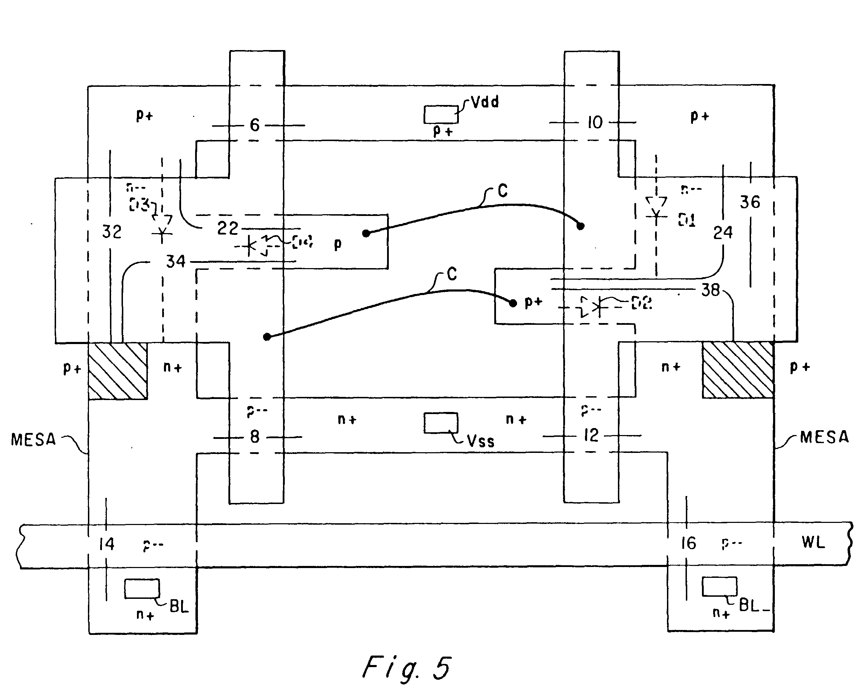

An alternative embodiment which also has increased capacitance within the same cell area forms a p+ region on each side of the cell in the layout of figure 4. This embodiment is illustrated in figure 5 which like figure 4 is a drawing of a portion of superimposed fabrication masks which show the layout of a circuit. The positions of these subject p+ regions are indicated by the diagonal lines. Figure 5 shows substantially the same layout as figure 4 as well as the positions of elements formed as a consequence of the added p+ regions.

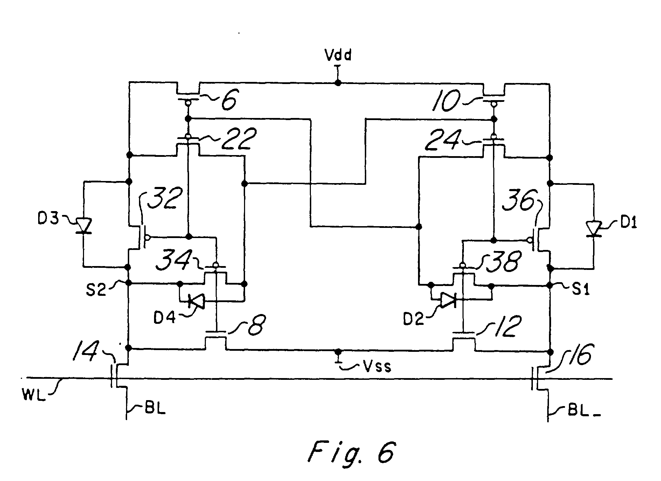

A schematic drawing of the circuit achieved from the layout shown in figure 5 is illustrated in figure 6. The added p+ region on the right side of the cell helps form p-channel transistors 32 and 34. The added p+ region on the left side of the cell helps form p-channel transistors 36 and 38. The positions of transistors 32, 34, 36, and 38 are indicated in figure 4 where lines on either side of the label numbers indicate extension of the transistors along the length of the transistor. Note that transistors 32, 34, 36, and 38 are each in parallel with a diode. When either nodes S1 and S2 are high, this arrangement helps keep them high since extra paths from Vdd are provided. Additionally, the addition of transistors 32, 34, 36 and 38 increase READ speed over that achieved by a circuit without them. SEU protection is achieved by the capacitance introduced by the transistors and diodes which contribute sufficient RC time constant delay to allow recovery of the memory cell from a energetic particle hit. Furthermore, like that of figure 4 extra capacitance results from the extension of gate areas over mesa areas as shown in figure 5. This too contributes to capacitive delay in the circuit which increases SEU hardening. As with figure 3 the WRITE and READ speeds of the circuit shown in figure 6 is not substantially increased over the WRITE and READ speeds of the circuit in figure 3.

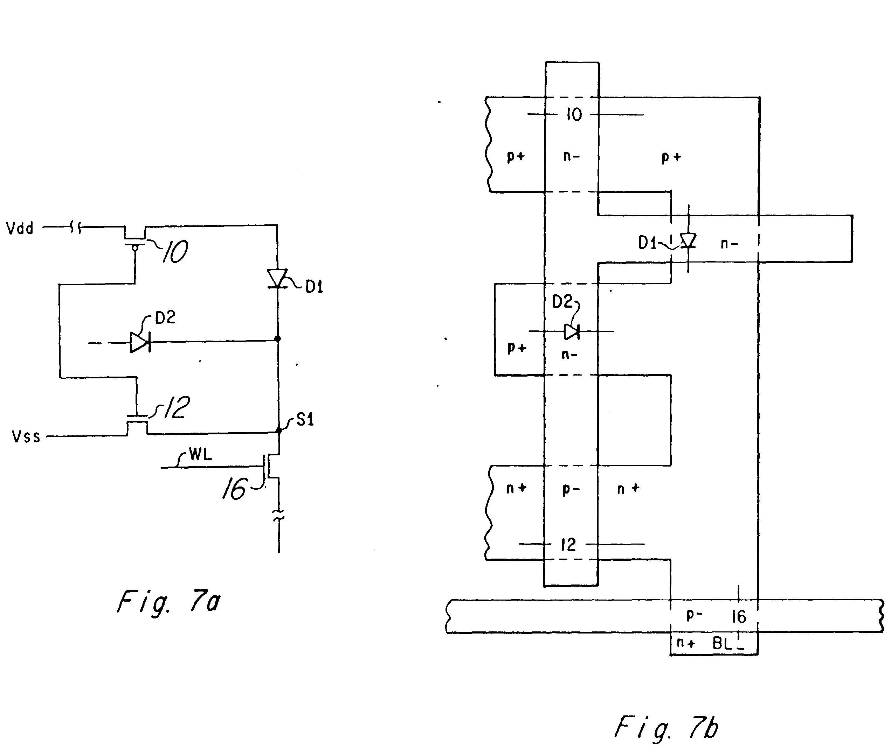

Figure 7a is a schematic drawing of another alternative embodiment of the invention. Only one half of the cell is shown for ease of illustration. Similar elements exist on the other side of the cell since this is a symmetrical structure. Transistors in the cross-coupling have been eliminated, thus as shown figure 7a is similar to figure 3 except that figure 3's transistor 24 is no longer present. Therefore transistor 22 can be eliminated as well. This cell like the other previously discussed embodiments allows increased capacitance within a give cell size.

A layout of the circuit of figure 7a is shown in figure 7b which illustrates superimposed mask portions. The positions of the transistors and diodes of figure 7a are labeled as well as the doping types in a manner similar to that of figure 4. Note that the layout of figure 7b is achieved by more narrowly extending the common gate of transistors 10 and 12 over the mesa between transistors 10 and 12.

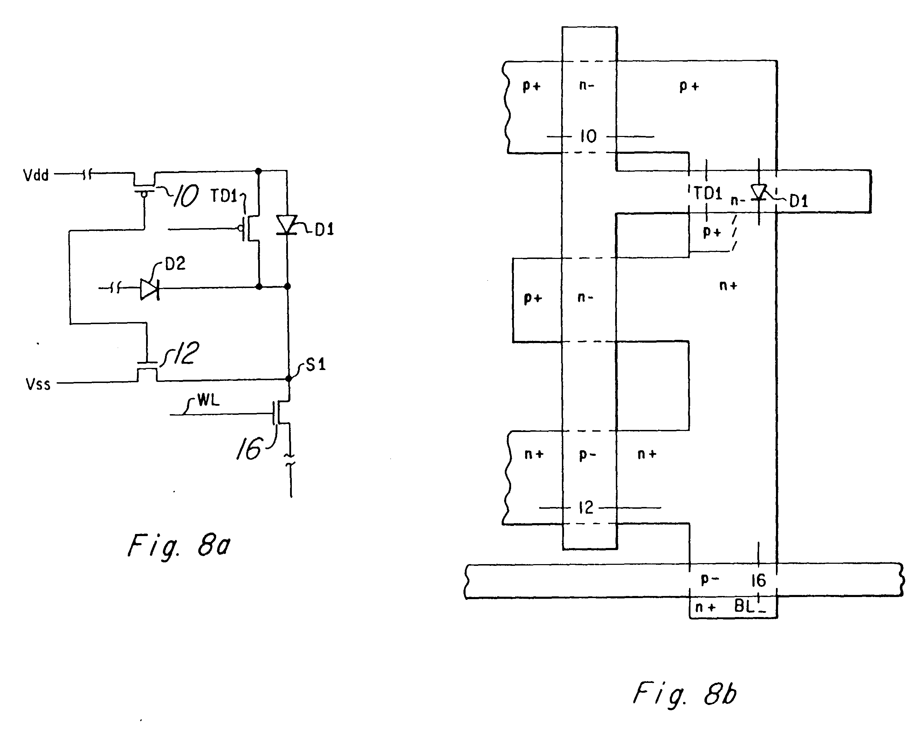

Figure 8a is an alternative embodiment of the schematic drawing illustrated in figure 7a. Figure 8a is the same as figure 7a except that transistor TD1 has been added so as to be in parallel with diode D1. Another transistor can be placed in parallel with a diode on the other side so as to maintain symmetry in the cell.

Figure 8b illustrates the same layout of figure 7b with the exception that a p+ region has been added which is connected to an adjacent n+ region as indicated by the diagonal slash marks at the boundary of the n+ and p+ regions. The connection may be made with silicide or metal for example. This p+ region causes the formation of transistor TD1 as indicated by the labeled position of transistor TD1.

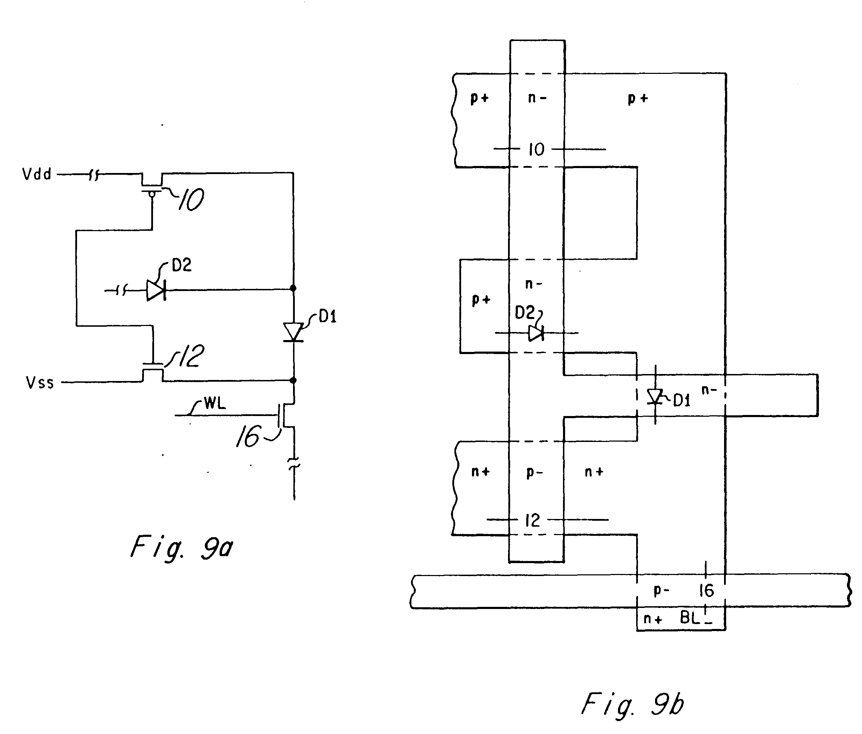

A variety of transistors and diodes may be formed by the extension of the gate common to transistors 10 and 12 of the foregoing drawings over the mesa between transistors 10 and 12. These transistors and diodes can provide increased delay without significantly slowing WRITE or READ speeds. A symmetrical arrangement results when a similar gate extension is performed on the other half of the cell. Figures 9a and 9b represent a schematic drawing and layout respectively, of half of a circuit. The elements, doping types, and connected adjacent regions are indicated as in the previous drawings. Note however, that the extension of the gate common to transistors 10 and 12 is closer to transistor 12.

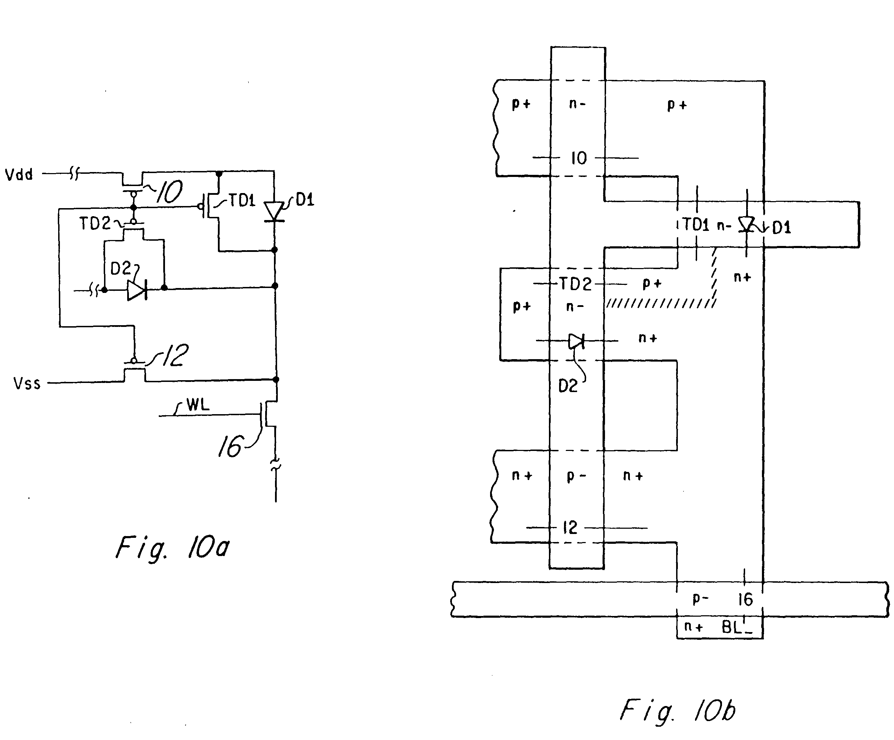

Figure 10a is a schematic drawing of an alternative embodiment of the schematic of figure 7a. This drawing is nearly the same as that of figure 7a with the exception that transistors TD1 and TD2 are in parallel with diodes D1 and D2 respectively.

Figure 10b is a layout of the circuit of 10a which adds a p+ region connected to an adjacent n+ region as indicated by the diagonal slash marks at the boundary of the n+ and p+ regions. As before, a symmetrical arrangement exists on the other side of the cell.

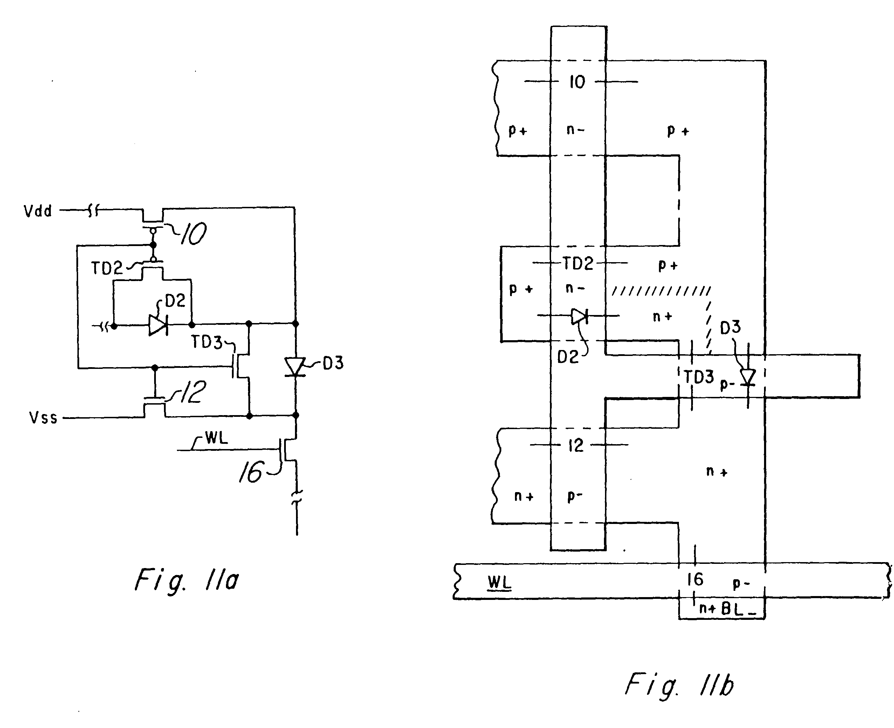

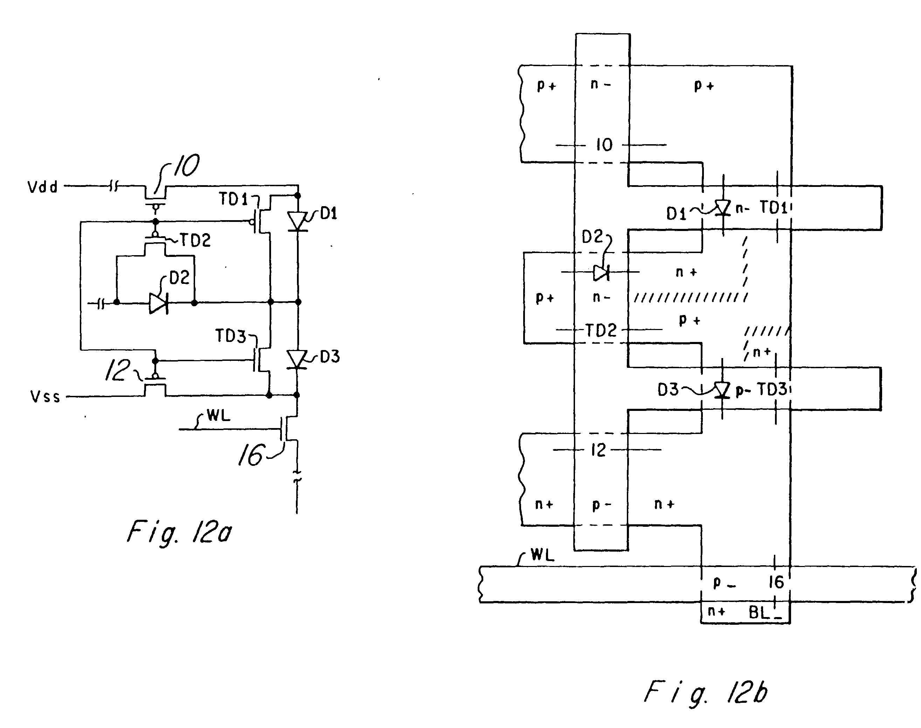

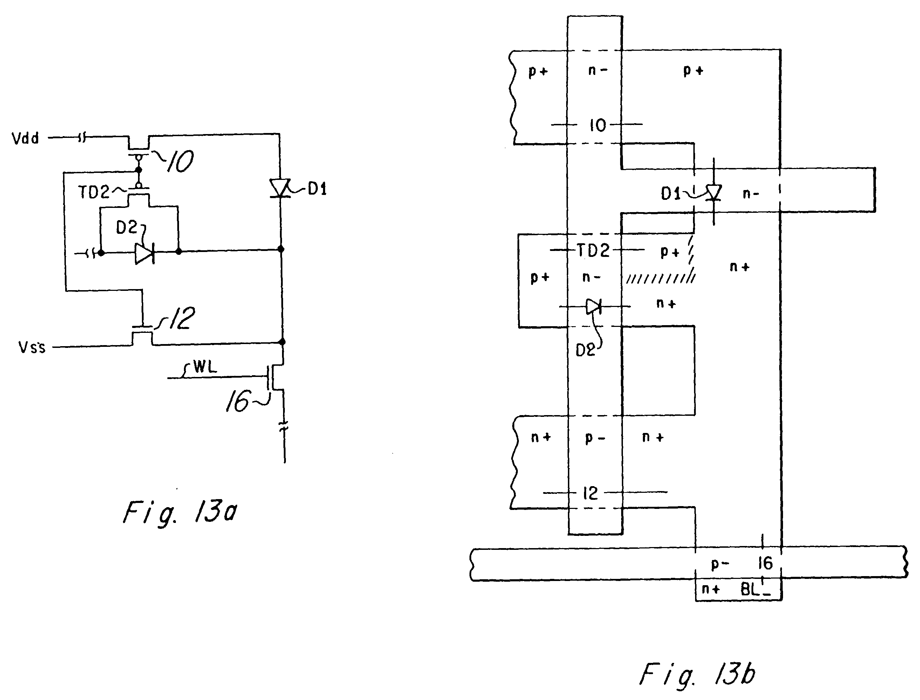

Still other embodiments of the invention are shown in the schematic drawings illustrated in figures 11a, 12a, and 13a. Their corresponding layouts, which optimize the amount of delay through the addition of capacitance without significantly slowing WRITE or READ speeds, are shown in figures 11b, 12b, and 13b respectively. These figures illustrate superimposed mask portions that are indicative of the position of elements in the schematic drawings. The elements, doping types and connected adjacent regions are indicated as before with the previous drawings. Figures 11a and 1b place two transistors TD2 and TD3 in parallel with two diodes D2 and D3 respectively . Figure 12 places three transistors TD1, TD2, and TD3 in parallel with three diodes D1, D2, and D3 respectively. Figures 13a and 13b place one diode D2 in parallel with one transistor TD2.

Although the invention has been described in detail herein with reference to its preferred embodiment and certain described alternatives, it is to be understood that this description is by way of example only, and is not to be construed in a limiting sense. It is to be further understood that numerous changes in the details of the embodiments of the invention, and additional embodiments of the invention, will now be apparent to, and may be made by a person of ordinary skill in the art having reference to this description. For instance, n-channel transistors may be substituted for p-channel transistors consistently throughout and vice-versa. Additionally p-type areas may be substituted with n-type areas and vice-versa. Alternatively, other load devices can be substituted for the transistor loads in the memory cell. Other active, as well as passive loads are contemplated. Although complementary field effect transistors such as CMOS transistors are shown in the drawings as illustrative of memory cell elements, bipolar transistors, JFETs and MESFETs are also contemplated. Furthermore, the foregoing described invention may be fabricated on a thin film of semiconductor material, such as silicon, which overlies an insulator as is done in silicon on insulator technology. It is contemplated that all such changes and additional embodiments are within the scope of the invention as claimed below. Accordingly, the invention is intended to be limited only by the scope of the appended claims.

## Claims

1. A memory cell comprising:
two cross-coupled inverters each including a p-channel transistor (6, 10) and an n-channel transistor (8, 12), said p and n channel transistors in each inverter sharing a common gate, each inverter further including a first diode (D1,D3) connected to and between the n-channel transistor and the p-channel transistor;
characterized by
a second diode (D2, D4) connected between and to the gate of a selected transistor (6, 8) of one inverter and a drain of a selected transistor (10, 12) of the other inverter.

2. A memory cell according to claim 1 wherein the gate common to said p and n channel transistors of an inverter also overlies said first or second diodes

3. A memory cell according to claim 1 or claim 2 wherein in each inverter the second diode (D2, D4) connects to the drain of said n-channel transistor (8, 12).

4. A memory cell according to claim 3 wherein in each inverter a coupling transistor (22, 24) is connected to the anode of said second diode (D2, D4) and the drain of the p-channel transistor (6, 10).

5. A memory cell according to claim 4 wherein said coupling transistor is a p-channel transistor.

6. A memory cell according to any one of the preceding claims, characterised in that the drains of said p-channel and n-channel transistors in each inverter are formed adjacent to each other to form a diode therebetween and said shared common gate in each inverter extends over said diode.

7. A memory cell according to claim 6 wherein in each inverter said shared common gate extends over and past the drains of said p-channel and said n-channel transistors.

## Patentansprüche

1. Speicherzelle mit
zwei kreuzgekoppelten Invertern, die jeder einen P-Kanal-Transistor (6, 10) und einen N-Kanal-Transistor (8, 12) enthalten, wobei sich die P- und N-Kanal-Transistoren in jedem Inverter einen gemeinsamen Gateanschluß teilen und jeder Inverter darüberhinaus eine erste Diode (D1, D3) enthält, die zwischen dem N- und P-Kanal-Transistor liegt und mit diesen verbunden ist;
gekennzeichnet durch:
eine zweite Diode (D2, D4), die zwischen dem Gateanschluß eines ausgewählten Transistors (6,8) des einen Inverters und einem Drainanschluß eines ausgewählten Transistors (10, 12) des anderen Inverters liegt und mit diesen verbunden ist.

2. Speicherzelle nach Anspruch 1, in der der gemeinsame Gateanschluß der P- und N-Kanal-Transistoren eines Inverters außerdem über der ersten oder zweiten Diode liegt.

3. Speicherzelle nach Anspruch 1 oder 2, in der in jedem Inverter die zweite Diode (D2, D4) mit dem Drainanschluß des N-Kanal-Transistors verbunden ist.

4. Speicherzelle nach Anspruch 3, in der in jedem Inverter ein Kopplungstransistor (22, 24) mit der Anode der zweiten Diode (D2, D4) und dem Drainanschluß des P-Kanal-Transistors (6, 10) verbunden ist.

5. Speicherzelle nach Anspruch 4, in der der Koppelungstransistor ein P-Kanal-Transistor ist.

6. Speicherzelle nach einem der vorhergehenden Ansprüche, dadurch gekennzeichnet, daß die Drainanschlüsse der P- und N-Kanal-Transistoren in jedem Inverter aneinander angrenzend gebildet sind, um eine Diode dazwischen zu bilden, und daß sich der gemeinsame Gateanschluß in jedem Inverter auf die Diode erstreckt.

7. Speicherzelle nach Anspruch 6, in der sich in jedem Inverter der gemeinsame Gateanschluß auf die Drainanschlüsse der P- und N-Kanal-Transistoren und darüber hinaus erstreckt.

## Revendications

1. Cellule mémoire comprenant :
- deux inverseurs couplés en croix comprenant chacun un transistor à canal P (6,10) et un transistor à canal N (8,12), lesdits transistors à canal P et N de chaque inverseur partageant une grille commune, chaque inverseur comportant en outre une première diode (D1, D3) disposée entre le transistor à canal N et le transistor à canal P et connectée à ceux-ci, caractérisé en ce qu'il comporte une deuxième diode (D2, D4) disposée entre et reliée à la grille d'un transistor sélectionné (6,8) d'un inverseur et un drain d'un transistor sélectionné (10,12) de l'autre inverseur.

2. Cellule mémoire selon la revendication 1, dans laquelle la grille commune desdits transistors à canal P et N d'un inverseur recouvre aussi lesdites première et deuxième diodes.

3. Cellule mémoire selon l'une des revendications 1 et 2, dans laquelle dans chaque inverseur la deuxième diode (D2,D4) relie le drain dudit transistor à canal N (8,12).

4. Cellule mémoire selon la revendication 3, dans laquelle dans chaque inverseur un transistor de couplage (22,24) est relié à l'anode de ladite deuxième diode (D2,D4) et au drain du transistor à canal P.

5. Cellule mémoire selon la revendication 4, dans laquelle ledit transistor de couplage est un transistor à canal P.

6. Cellule mémoire selon l'une quelconque des revendications précédentes, caractérisée en ce que les drains des transistors à canal P et à canal N de chaque inverseur sont formés de façon adjacente les uns aux autres pour former entre eux une diode et ladite grille commune partagée de chaque inverseur s'étend au-dessus de ladite diode.

7. Cellule mémoire selon la revendication 6, dans laquelle dans chaque inverseur ladite grille commune partagée s'étend au-dessus et au-delà des drains des transistors à canal P et à canal N.
